(19) Europäisches Patentamt / European Patent Office / Office européen des brevets

(11) **EP 4 409 708 B1**

(12) **EUROPEAN PATENT SPECIFICATION**

(45) Date of publication and mention
of the grant of the patent:
**17.09.2025 Bulletin 2025/38**

(21) Application number: **22790544.5**

(22) Date of filing: **29.09.2022**

(51) International Patent Classification (IPC):
*G01R 31/52* (2020.01)    *H02H 3/40* (2006.01)
*G01R 31/08* (2020.01)    *H02H 7/26* (2006.01)
*H02H 1/00* (2006.01)

(52) Cooperative Patent Classification (CPC):
**H02H 7/26; G01R 31/086; G01R 31/52; H02H 3/40;**
H02H 1/0092

(86) International application number:
**PCT/EP2022/077183**

(87) International publication number:
**WO 2023/052540 (06.04.2023 Gazette 2023/14)**

(54) **CALCULATION OF MORE ACCURATELY ESTIMATED LOCATION OF GROUND FAULT SHORT CIRCUITS IN COMPLEX RAILWAY POWER SUPPLY ARRANGEMENTS**

BERECHNUNG DES GENAUER GESCHÄTZTEN STANDORTES VON ERDSCHLUSSKURZSCHLÜSSEN IN KOMPLEXEN EISENBAHNSTROMVERSORGUNGSANORDNUNGEN

CALCUL D'EMPLACEMENT ESTIMÉ PLUS PRÉCISÉMENT DE COURTS-CIRCUITS DE DÉFAUT DE MISE À LA TERRE DANS DES AGENCEMENTS COMPLEXES D'ALIMENTATION ÉLECTRIQUE FERROVIAIRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.09.2021 GB 202113900**

(43) Date of publication of application:
**07.08.2024 Bulletin 2024/32**

(73) Proprietor: **Siemens Mobility Limited
London, NW1 2PL (GB)**

(72) Inventor: **OLLERENSHAW, Richard
York YO10 3AX (GB)**

(74) Representative: **Siemens Patent Attorneys
Postfach 22 16 34
80506 München (DE)**

(56) References cited:
**CN-A- 106 443 354    CN-A- 112 180 217**

**Description**

The present invention relates to methods and apparatus for estimating a location of a ground fault short circuit in a railway electrical power supply network.

An undiagnosed short circuit fault can lead to repeated train delays, causing disruption to users and costing hundreds of thousands of pounds per event and/or may lead to asset failure. Rapid and accurate location of short circuit events is key to infrastructure management.

By calculating a rapid and accurate estimate of a location of the short circuit, the present invention reduces the amount of time that workers have to spend looking for a fault. It has been commonplace for workers to patrol long sections (>10km) of track, searching for evidence of electrical damage.

Typically, short circuit faults are between a power line and ground. Power lines in railway electrical power supply networks may be overhead lines, "third rail" conductors running alongside the rails, or other arrangements as appropriate.

Many types of disturbance may lead to a short circuit, for example, mechanical damage by trains, debris connecting live conductors to earth, tree branches falling on conductors, or persons in contact with live equipment. It is required to be able to provide an accurate estimate of the location of the short circuit in order to timely dispatch a maintenance team to remove the short circuit and make good any damage.

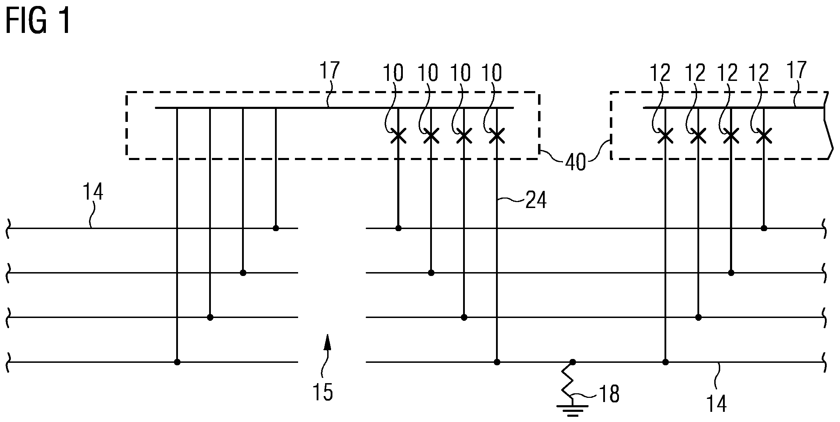

Fig. 1 shows an example railway power supply arrangement, which is conventional in itself.

In this example arrangement, power supply arrangements to a section of four parallel tracks are illustrated. The tracks themselves are not represented, for ease of illustration. Electrical power is provided from a supply site, not illustrated, which may be considered to lie off to the left of the illustrated section of the power supply arrangements.

Power line conductors 14 are arranged to supply power to trains passing along an associated track. As is well known to those familiar with the art, power line conductors 14 include interruptions 15 at intervals. Supply substations 40 are schematically represented. Current may be carried past the interruptions 15 by power bus bars 17 within respective supply substations 40, which carry current from power line conductors 14 on one side of an interruption to power line conductors 14 on the other side of that interruption 15. Electrical current is carried between power line conductors 14 and power bus bars 17 by "feeders" 24. Protection devices 10, 12, which may be referred to as "relays" or IEDs (Intelligent Electronic Devices) are provided for each feeder 24. It is conventional in itself that these relays (IEDs) are equipped to measure the respective voltage of the supply and the current passing through the associated feeder 24.

Feeders 24 with associated relays 10, 12 provide power connections near ends of conductors 14, either side of interruptions 15. The conductors 14 which may each be of length varying about 1 - 20km. The supplied power typically may be AC (e.g 16.7, 25, 50 or 60Hz at a supply voltage in excess of 10kV) or DC (e.g. at a supply voltage of 660-3000V).

Each electrical conductor 14 is held at the supply voltage, and little current flows through respective feeders 24 unless a train is passing and drawing current from the conductor 14. When a train passes, it draws current from the respective conductor 14, which is usually embodied as an overhead line (OHL) or conductor rail, and the current returns to the supply, through contact with the rails. More complex feeding scenarios exist, including additional substations connected to the same conductor 14, and varying conductor types throughout the length of the associated railway track.

An earthing short circuit fault is schematically represented at 18. A fault, caused by damage or otherwise, has caused a current path to exist between a conductor 14 and ground. A current flows from conductor 14 to ground at this location.

Protection systems, conventionally provided in rail power supply arrangements, detect the occurrence of a short circuit 18 to ground, and disconnect power from the affected conductor 14. However, the location of the short circuit fault 18 may be unknown.

This issue is well known, and methods are known to derive an approximate location of the earthing short circuit fault 18 in AC supply networks. Some such methods involve protection relays calculating the magnitude and phase of a measured fundamental frequency voltage and current components during an earthing short circuit fault and comparing the results to an assumed impedance of the whole conductor length between relays 10, 12. In the simple case of a conventional arrangement such as illustrated in Fig. 1, this calculation may be performed by feeder protection relays 10, 12 at the feeders 24, assuming a constant impedance per unit length of conductor 14. An approximate distance of the short circuit 18 from each relay may thereby be calculated.

Conventionally, a magnitude and phase of the fundamental frequency component of the voltage and current is measured over a period of the fault by feeder protection relays 10, 12 at the feeders 24. Dividing the measured supply voltage by the measured supply current for a particular conductor 14 gives an apparent "fault impedance". This may be compared to a predetermined impedance of the corresponding full line section. By assuming that the conductor has a constant reactance per unit length, a prediction of the location of the fault may be determined as a percentage of the full line length of the conductor. In DC networks there is no phase and only the resistance per unit length can be considered, leading to substantial error at least partly due to the unknown resistance within the short circuit fault.

Such methods have however been found to lack accuracy in results, meaning that lengthy parts of the conductor 14, typically several kilometres, have to be examined for damage in order to find the actual location of the short circuit fault 18, in turn meaning a significant interruption to train services while inspection and repair is carried out. It may be found difficult or impossible to identify a cause of repeating transient short circuits.

It is found in practice that the inductance of the conductor 14 is not constant per unit length, but varies according to factors such as current flows in adjacent conductors. Other errors influence the estimate of the location of the short circuit fault, such as errors in calculation of the assumed line impedance; errors in measurement of voltage, current and phase, which may be partially due to the presence of AC harmonics and DC inrush disturbances.

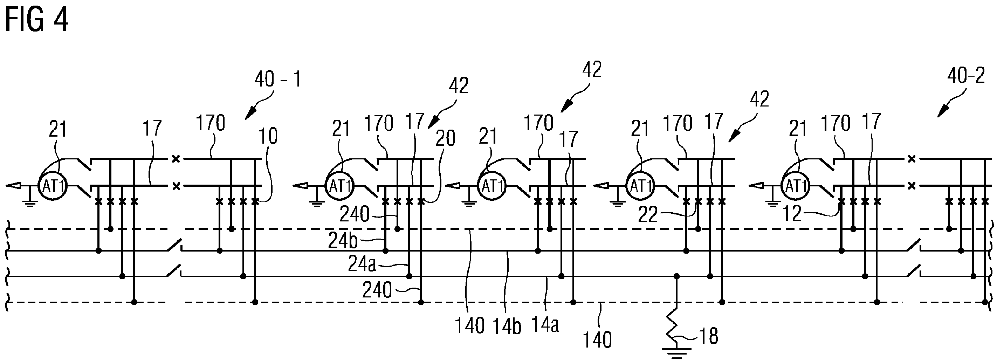

Other problems with such methods arise where an installation includes further connections providing current feed to the conductor 14, for example an autotransformer. An autotransformer arrangement will be discussed below with reference to Fig. 4. Such arrangements make it difficult to distinguish between a fault load and a regular load, as the measured impedance does not vary in proportion to the distance to the fault and the same impedance may be measured in the case of faults in multiple different locations. Such configurations may be termed "mesh feeding" due to the limited electrical sectioning and multiple infeeds to each electrical section. Such installation include multiple current paths. It has been found that current flowing along these paths may affect the actual impedance of the conductor 14 being measured. This contributes to operational experience which shows that predicted fault locations can be far from an actual fault location. A "mesh feeding" arrangement is discussed below, with reference to Fig. 4.

Additionally, in the case of systems designed for improved safety and reliability through very fast fault clearance, there may be insufficient fault waveform data for the magnitude and phase of fault voltage and current to be accurately calculated, making identification of the location of intermittent faults difficult with conventional methods.

CN112180217A relates to a power distribution network single-phase earth fault section position determination method and system, using a trained one-dimensional convolutional neural network to perform the fault section determination. CN106443354A describes a high-speed rail line fault detection system that can determine the distance of a fault away from a transformer station using optimal correction coefficients and optimal current distribution coefficients and measured currents at a transformer.

The present invention therefore aims to provide methods for estimating a location of an earthing fault short circuit along a length of AC or DC railway power supply conductor.

Therefore, the present invention provides methods as defined in the appended claims.

The above, and further, objects, characteristics and advantages of the present invention will become more apparent from the following description of certain embodiments thereof, by way of example only with reference to the accompanying drawings, wherein:

Fig. 1 shows a conventional simple arrangement of power supply equipment for a railway;

Fig. 2A shows a very simple arrangement of power supply equipment for a railway which may benefit from the present invention;

Fig. 2B illustrates example current waveforms of such an arrangement;

Fig. 3A shows another simple arrangement of power supply equipment, similar to the arrangement of Fig. 1, which may benefit from the present invention;

Fig. 3B illustrates example current waveforms of such an arrangement;

Fig. 4 shows an overview of electrical connections in a mesh-fed arrangement with autotransformers, which may benefit from the present invention;

Fig. 5 shows measured voltage waveforms from feeders 24 supplying conductors 14 in an arrangement such as shown in Fig. 1 or Fig. 3A;

Fig. 6 graphically represents data stored in a look up table, representing currents flowing in respective conductors at a first substation 40-1 in the presence of a short circuit fault 18; and

Fig. 7 graphically represents data stored in a look up table, representing currents flowing in respective conductors at a second substation 40-2 in the presence of the short circuit fault.

The present invention provides improved methods for estimating a location of an earthing fault short circuit 18 in a railway power conductor. The present invention utilises measurements of voltages and currents within the supply network taken prior to disconnection of power from a conductor 14 on detection of a short circuit, and uses those measurements to estimate a location of the short circuit.

In conventional methods for calculating a location of a short circuit, individual IEDs compare the voltage and current at their individual measurement inputs to calculate a reactance value for AC networks, or resistance for DC networks. In AC networks, mathematical techniques are used to derive the fundamental frequency waveform over a duration of one or more cycles of the fault current.

According to certain embodiments of the present invention, the relays (IEDs) take and store measurements of the current and voltage waveforms at a high sample rate, for example, greater than 800 samples/sec, prior to disconnection of the conductor which has suffered the short circuit. The current and voltage waveforms are measured for all conductors 14 supplied by all relays 10, 12 which feed current to the short circuit fault. The measurement data is stored and processed to calculate an estimated location of the short circuit fault.

In preferred embodiments of the present invention, waveforms of current and voltage are collected from all IEDs at a substation, and synchronised instantaneous current magnitudes are derived for a combined analysis.

According to the present invention, voltage and current waveforms are analysed for all conductors 14 supplied by all relays 10, 12 at substations which are feeding current to the ground short circuit fault 18.

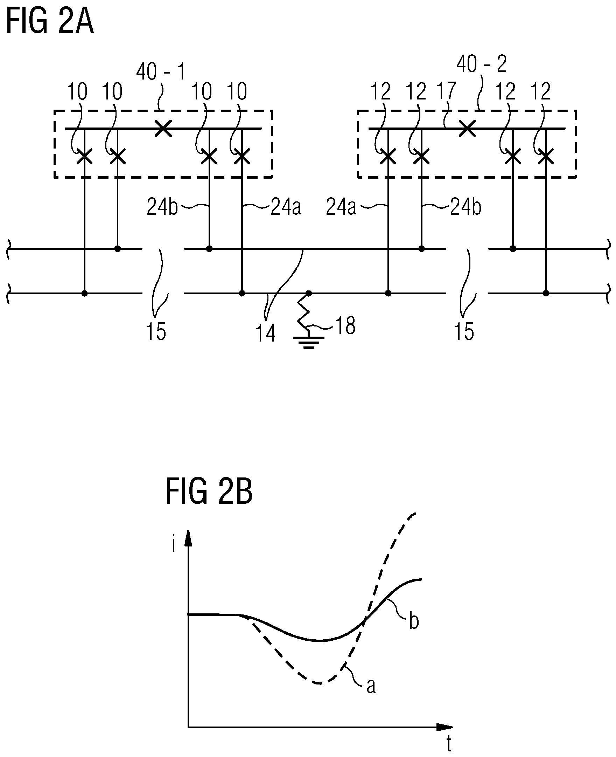

Fig. 2A shows a simple example of a railway power supply arrangement which may benefit from the present invention, while Fig. 2B illustrates example AC current waveforms as may be measured in such an example installation. In this example, two parallel railway tracks are considered, each supplied with electrical power by conductors 14. In a method of the present invention, ground short circuit fault 18 is detected, and respective current waveforms a, b are measured, being current waveforms as supplied through respective feeders 24a, 24b at supply substation 40-1. Similar measurements are preferably also taken for respective feeders 24a, 24b at non-supply substation 40-2.

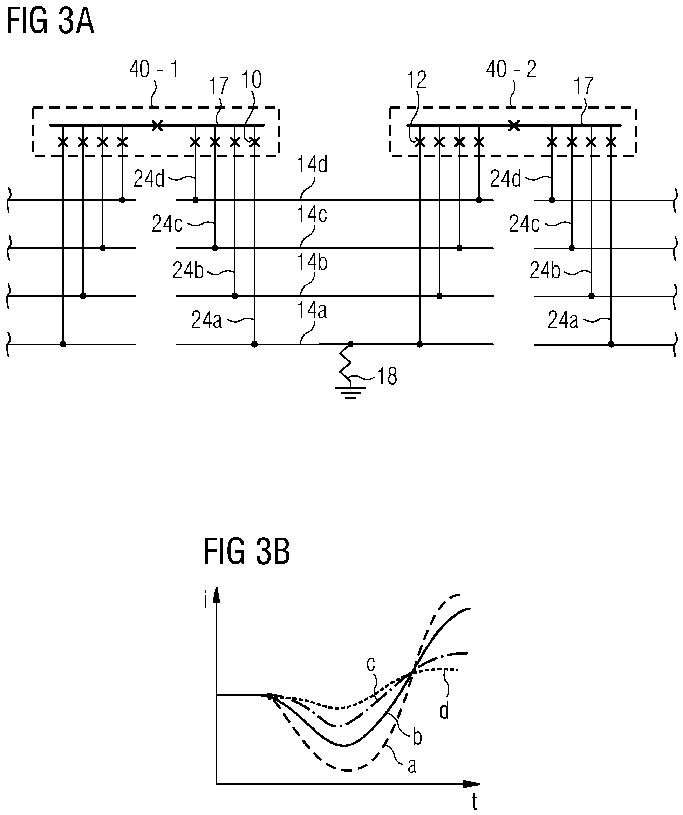

Fig. 3A shows another example which may benefit from the invention, while Fig. 3B illustrates example current waveforms measured in such a setting. The arrangement of Fig. 3A resembles the arrangement of Fig. 1, and represents four parallel railway tracks, each supplied with electrical power along conductors 14. In this case, the ground short circuit fault 18 is fed by four track feeders 24a-24d at each end of the conductors 14a-14d, because the conductors 14a-14d are electrically joined together at each end by busbars 17 within supply substations 40-1 and 40-2. For each of these track feeders, once a ground short circuit fault 18 has been detected, measured data representing respective current waveforms a, b, c, d are stored as disturbance records, representing current and voltage waveforms at respective feeders 24a, 24b, 24c, 24d. Comparison of disturbance records, representing current and voltage waveforms from each of these track feeders, enables a location of the ground short circuit fault 18 to be uniquely calculated.

In each case, it may be assumed that the conductor showing the largest peak current is the one which is experiencing a ground short circuit fault 18 - conductor 14a in the illustrated example. With the method of the present invention, calculation of the unique location of the ground short circuit fault 18 may be performed even where it occurs on length of conductor beyond a final substation feeder, which was not possible with conventional methods.

The inventors have found that the location of a ground short circuit fault 18 may be calculated as a function of the currents flowing in all of the track feeders 24a-24d of all of the relays 10, 12 which feed into the fault 18. In arrangements such as illustrated, where parallel conductors are electrically connected by busbars 17 at the substations 40, it is found that all feeders 24a-24d supply current to the ground short circuit fault 18.

Although the inventor has found that in principle it is possible to derive general equations to calculate the location of a ground short circuit fault, they have found that such generalisations become prohibitively complex in the case of practical feeding arrangements which consider cable connections and varying mutual impedances.

The voltage and current at each feeder 24a-24d may be measured at a high sample rate by existing IED technology. A rolling memory buffer is maintained, and the data within the rolling memory buffer is committed to a non-volatile memory, as a disturbance record, when the IED detects a ground short circuit fault 18. In the present invention, on detection of a ground short circuit fault by one IED, fault data is recorded at all feeders 24a-24d, for example by rapid communication such as by IEC61850 GOOSE and custom IED logic to trigger disturbance recordings in all IEDs 24a-24d, including those feeding healthy electrical sections 14b-14d. In some example embodiments, these disturbance recordings are then automatically file-transferred to a central device connected to the same communication network, such as a Siemens (RTM) SIMATIC industrial PC.

Conventionally, impedance measurements were based on a single magnitude and phase measurement of the fundamental frequency component, measured at a single track feeder. By comparing all the disturbance records, including those of parallel healthy feeders 24b-24d, the present invention is capable of estimating a fault location in AC and DC powered railways, even in installations employing mesh feeding; those with nonlinear impedance with respect to distance; and advanced systems with sub-cycle fault clearance durations.

Accordingly, disturbance currents and voltages in all conductors are examined. The inventors have found that, by analysing voltage and current waveforms on all conductors 14 connected to each relay 10, 12, an accurate location of a ground short circuit fault 18 anywhere along the length of a conductor 14 may be derived. A detection of a short circuit, which in itself may be performed by any suitable means familiar to those skilled in the art, may be used to commence recording or storage of data representing waveforms of current and voltage on all conductors 14 connected to the substations 40-1, 40-2. All of the recorded waveform data may then be analysed together to calculate an estimated fault location.

In an embodiment of the present invention, voltage and current measurements for all conductors 14 and feeders may be stored within the associated substation 40. For example, a suitable computer system may be provided with suitable instrumentation and memory to store a buffer of data representing current and voltage in all relays (IEDs) and feeders connected to that substation.

In an example method, analysis of the disturbance record representing stored voltage and current waveform data may include the following steps.

The first signal to indicate a fault is examined. This is likely to be from the closest IED 10, 12 on the electrical section conductor 14a which experiences a short circuit fault 18 to ground. A rapid change in current and voltage occurs on all feeders and is used to synchronise the collected fault recordings, and to identify any circuits that are not in service. Techniques such as cubic spline interpolation may be employed for time synchronisation of the collected current data. A maximum current value across all feeders is detected and compared with the instantaneous currents supplied to all other conductors at the same time. This method is not dependent on fault durations exceeding one or more cycles to allow phasor measurement, and may be employed even where the fault is interrupted before the prospective maximum current is reached, which supports the use of advanced fault clearance and mitigation technologies providing safety and reliability benefits.

The synchronised combination of instantaneous current data may be used to uniquely identify a fault location even in DC and complex mesh fed AC networks, and improve accuracy in the case of resistive faults.

*In a simple example case, a two-track railway consisting of two parallel electrical sections of length 10km and uniform impedance 3.6+j10.5 Ohms each, is supplied by a feeder substation at one end with nominal 26.25kV voltage and 0.1+j4.2 Ohms, and with a paralleling substation at the remote end. For a fault that is d km from the feeder substation, the total fault current may be expressed as:*

*(26.25kV/(0.1+j4.2 + ((d \* 0.36+j1.05)^-1 + ((20-d) \* 0.36+j1.05)^-1)^-1).*

*At the supply substation, the short circuit may be assumed to lie on the feeder with highest current, at a distance* d *which may be calculated from the proportion of current supplied from the supply substation through that feeder ("current1") divided by the current supplied through the other feeder ("current2"), which varies with distance as shown. Distances between 0 and 10km are distance from the supply-side substation 40-1 along the relevant feeder, and distances between 10km and 20km refer to a total 'hairpin' distance from the supply-side substation 40-1 to the next substation 40-2 and returning to the fault along a relevant feeder.*

```
d = 20 * (current 1 / current 2) * (1 + current 1 / current 2)^-1
```

However, the inventors have found that such a simple approach does not provide useful results in practical cases, where variation in electrical infrastructure and mutual impedance mean that the uniform case above is inaccurate.

Fig. 4 schematically illustrates a more complex power supply arrangement, which is in fact common on UK railways. Features common with other drawings carry corresponding labels. Again, electrical power is provided from a supply site, not illustrated, which may be considered to lie off to the left of the illustrated section of the power supply arrangements.

Supply substations 40-1 and 40-2 are shown, supplying respective relays (IEDs) 10, 12. Each of the relays supplies at least one conductor 14, typically an overhead line (OHL) through a respective feeder 24.

In the arrangement of Fig. 4, supply substations 40 are provided with autotransformers 21. These invert the polarity of the supply voltage to conductors 14, and supply the inverse voltage through autotransformer feeders 240 to autotransformer lines 140, shown in phantom in the drawing. Between supply substations 40 are provided autotransformer substations 42. At each of the substations 40, 42, feeders 24 are electrically connected at busbar 17, while autotransformer feeders 240 are electrically connected together at a separate busbar 170. As required, the inverted supply voltage applied to autotransformer lines 140 may be connected to an autotransformer 21 at a certain substation 40, 42, and the inverted supply voltage may thereby be inverted again to and connected to busbar 17 to provide added power for supply to conductors 14. The multiple substations 40, 42 feeding each single electrical section conductor 14 is termed "mesh" connection, and it has conventionally been found difficult to calculate the location of a ground short circuit fault 18 in such an arrangement. However, by measuring current and voltage data in all feeders 24, 240 connected to conductors 14 or autotransformer lines 140, the present invention may be applied even to such mesh connected arrangements, and provide an accurate location estimate for a ground short circuit fault 18.

In an example method of the present invention, comparisons are made of the relative proportion of current flowing in the ground short circuit fault 18 which could be attributed to each feeder 24, 240. The feeder 24, 240 with the most direct connection to the fault will carry the greatest proportion of current. That feeder may then be be disconnected, but measurement data collected previous to the disconnection may be used to calculate a location of the ground short circuit fault 18.

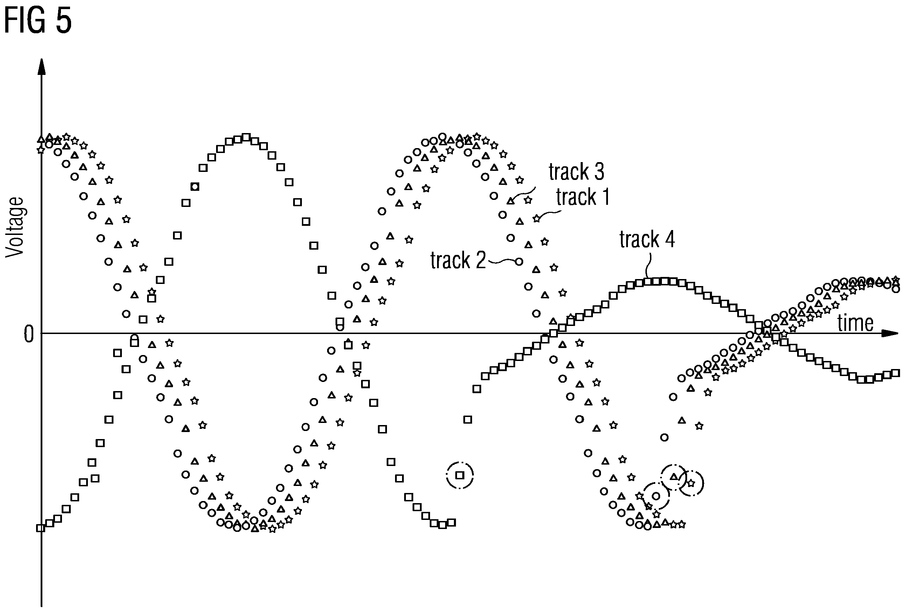

Fig. 5 illustrates voltage data measurements taken at relays 10, 12 at one substation supplying four railway tracks, such as in the examples of Figs. 1 and 3A. The data for each track, labelled "track 1" to "track 4" follows a 50Hz sinusoid, until a ground short circuit fault arises. In reality, in this example, all four tracks are supplied by a common AC voltage, and so, in reality, the sinusoidal voltages for all four tracks are synchronised.

As illustrated, the voltage measurement data are not synchronised: for example, towards the left-hand side of Fig. 5, the peak values of all four voltage sinusoids should occur at a same time. The data measured by respective relays 10, 12, 20, 22 must be synchronised before it can be used to calculate a location of the ground short circuit fault.

Towards the right-hand side of Fig. 5, there is a discontinuity in the sinusoidal voltage waveforms. This is as a result of the occurrence of a ground short circuit fault. As all four tracks are supplied from a common voltage at busbars 17, the fault 18 will affect the voltage on all tracks in the same way, although the currents flowing to the respective tracks will differ markedly. For each set of track feeder voltage data shown, one data point is circled. Those circled data points are the first data point in each case for which the voltage waveform exhibits the discontinuity. These data points are taken at a same time in reality. The apparent difference in timing is due to errors in synchronisation of the respective relays storing measurement data. Identification of the indicated data points may be used to synchronise the stored data for the respective tracks. Alternatively, techniques such as cubic spline interpolation may be employed to find the best fit between non-synchronised data.

The present invention proposes to simulate ground short circuit fault currents through the various relays 10, 12, 20, 22 for multiple fault locations on each conductor 14 using simulation software, which may be a known simulation software, such as SITRAS® SIDYTRACK. The simulated results are then stored in a look-up table, for comparison with data measured and stored for future detected short circuits.

Actual voltage and current measurements by the relays, in case of a real-life short circuit, can later be compared to scenarios represented in the stored simulated data in the look-up table. The scenario most closely resembling the actual measured voltages and currents may be taken as an approximation of the real-life short circuit, providing an accurate location of the short circuit, even for complex power supply arrangements including feeder cables, varying mutual impedance with respect to distance, mesh feeding and/or changing track and conductor configurations. The closest fit of a set of simulated data in the look up tables to actual measured data may be found, for example, using least-squares comparison of the relative measured currents. This is found to provide a more accurate result than the conventional simplified method described above.

Lookup tables can be produced with simulated voltage and current data for all feeders 24 in service, and also for maintenance cases where current measurements indicate that some feeders are out of service. This technique provides greatly improved accuracy compared to existing methods, and may be applied to fully sectioned or mesh fed, AC and DC, networks where conventional fault location methods cannot easily be applied.

In an embodiment of the present invention, relays (IEDs) sample current and voltage data continuously, storing in a buffer and over-writing with new data until a short circuit fault is detected. Then, the buffer data is transferred to non-volatile memory as a disturbance record for all relays (IEDs) within the substation where a fault is detected. This may include relays (IEDs) for parallel electrical sections to those directly feeding the electrical section which suffers the short circuit fault.

Preferably, a post-processing step is performed on the stored data of voltages and current in each feeder 24 and each conductor, to calculate a location estimate for the short circuit fault.

An example of a suitable post-processing method may proceed as follows:

- time signals of the measurements of the various feeders are synchronised;
- the instant of peak instantaneous current is identified;
- the magnitudes of currents in each feeder at that instant are compared;
- the relative proportions of currents in each feeder provide an indication of how far the short circuit defect is from each feeder along the associated conductor, by comparison with datasets in a corresponding look-up table.

Conventional arrangements only consider the voltage and current at a single IED. Conventional techniques exist to manually combine measurements from two ends of a single feeder after an event. The present invention enables combining data from all feeders at one supply site, including healthy feeders, for automatic analysis.

A ratio between currents through the faulty feeder 24, that is, the one carrying most of the current which flows through the short circuit fault, and currents through other paths, provides an indication of the relative location of the short circuit fault.

The inventors have found that impedance of conductors 14, typically OHL (over-head lines), is not uniform, making calculations complex. The conductor's impedance per unit length is found to vary according to many influences, such as connected equipment, geographic location. Indeed, due to the complexity of most real-world railway power supply installations, the inventor has found that a preferred method for finding the location of a short circuit fault in any particular rail power supply installation is to perform a series of simulations of short circuit faults at certain locations, and to store the current characteristics for all all feeders 24 and so through all conductors 14 for each simulated short circuit fault in a look-up table. When a short circuit fault develops for real, measurements of instantaneous currents in all feeders 24 and so in all conductors 14 are compared to stored data in the look-up table, and a set of result data is located which is most similar to the real-world measured short circuit current data. The corresponding simulation will indicate an estimated location of the short circuit fault which was assumed in that simulation, and it is likely that the current real-world short circuit fault will be at a similar location. It is therefore necessary to build up a comprehensive look-up table of data representing short circuit faults at many locations on many conductors within the railway power supply network of interest. This may be compared to the measured relative currents during an ongoing actual short circuit fault.

The calculations to identify a most-similar simulated scenario are based on ratios of current values through respective feeders 24, and so through respective conductors 14. Instantaneous values are used. In an example method according to the present invention, current measurement data over a period of 200ms representing the short circuit fault may have been stored. Within that 200ms data set, a correspondingly timed sample is used from each feeder to calculate instantaneous current ratios in the various conductors 14. Optionally, a plurality of sets of instantaneous current values at a certain time may be used, and average ratios of instantaneous currents used to form a data set of current ratios. That data set is used to compare with scenarios represented in the look up table, to identify which scenario is most similar to a current real-world short circuit fault. According to the invention, it is then assumed that the location of the current real-world short circuit fault will be at a location near to the location of the simulated short-circuit fault in the scenario represented in the look up table by the set of instantaneous current ratios which are most similar to the instantaneous current ratios presented by the current real-world short circuit fault.

In a preferred embodiment, the look-up table provides data on instantaneous currents due to short-circuit faults on all conductors 14 and feeders supplied by relays (IEDs) which are themselves supplied from a single electrical substation 40. This allows the railway network to be divided into parts of manageable size. Simulations and look up tables can be performed and created covering all conductors supplied by a given substation, and a real-world short circuit can easily be identified with a substation by measuring and detecting an increase of current flowing through that substation. Detection of such increase in current through the substation may then prompt retention of all buffered data relating to feeders 24 and conductors 14 supplied by that substation. The conductor showing the maximum value of instantaneous current may be disconnected from the electrical power supply by a protection system built into the relays (IEDs) or the substation 40, to halt current flow through the short circuit fault. Evaluation of ratios of instantaneous current in the various conductors may then be carried out, and the results compared to a look-up table representing that part of the railway network electrically supplied by that particular substation 40. Matching of real-world instantaneous current ratios to the relevant stored data in the look-up table enables an estimate of the location of the short-circuit fault to be derived.

While the conventional method was based on an assumed constant line impedance, and that a simple current/voltage ratio would provide an impedance value sufficient to calculate a distance to the short circuit fault, the present invention bases a deduction of the likely location of a ground short circuit fault 18 on an analysis of all affected currents on feeders 24, and the similarity of those currents to stored example simulations of possible ground short circuit fault locations, such that a most-similar simulation may be identified, and the fault location used for that most-similar situation is used as an estimated location for a present ground short circuit fault 18.

The invention can be implemented using existing infrastructure, requiring only adjusted configuration and the addition of a computer to collect and evaluate the data from each track feeder 24, and report the calculated fault location. The calculated location can then be transmitted to a network controller to allow remedial work to be planned.

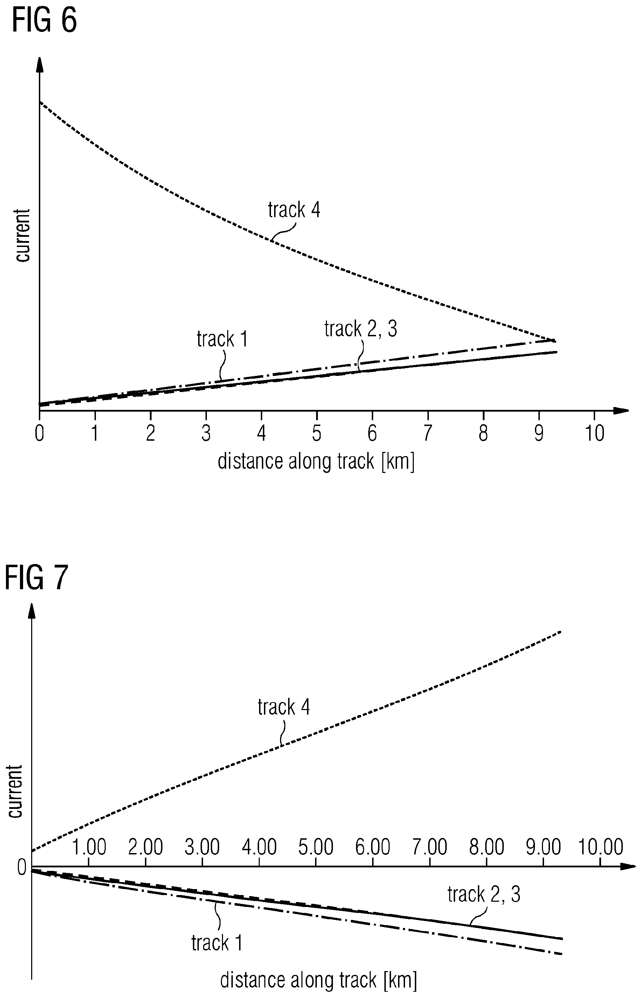

Fig. 6 graphically represents the contents of a look-up table which may be used in a method of the present invention. The various curves indicate simulated supply current to each of the four conductors 14 for the four parallel tracks. In Fig. 6, currents at a supply-side substation 40-1 are represented, with a ground short circuit fault occurring on track 4. As the supply voltage is different in different installations, and the impedance of the ground short circuit fault is not known in advance, the currents are represented as relative magnitudes on an arbitrary scale. The x-axis represents distance along the line from the supply-side substation 40-1 towards the non-supply side substation 40-2. In the illustrated example, this is a distance of 10km. For example, for a fault 18 at a distance 0km from supply-side substation 40-1, almost all current flows through the relay supplying track 4. As the distance from supply-side substation 40-1 increases, the proportion of current that flows through the relays supplying tracks 1-3 increases. In the event of a real-world ground short circuit fault being detected on track 4, stored measured voltage data from the relays associated with supply-side substation 40-1 may be used, as described with reference to Fig. 5, to synchronise corresponding stored measured current data through the relays, and the relative magnitudes of those currents may be compared to the look-up table represented by Fig. 6. A certain location along the track is found at which the relative magnitudes of the currents measured through the relays of supply-side substation 40-1 most resemble the relative magnitudes of the currents of the simulated data stored in the look up table. That certain location is the estimated location of the ground short circuit fault.

Fig. 7 resembles Fig. 6, and graphically represents the contents of another look-up table which may be used in a method of the present invention. The various curves indicate simulated current to each of the four conductors 14 for the four parallel tracks from a non-supply side substation 40-2, with a ground short circuit fault occurring on track 4. Again, the currents are represented as relative magnitudes on an arbitrary scale. The x-axis represents distance along the line from the supply-side substation 40-1 towards the non-supply side substation 40-2. In the illustrated example, this is a distance of 10km. As the look-up table represented by the illustration of Fig. 7 represents currents through relays of a non-supply side substation 40-2, the sum of the currents at any given location will be zero.

For example, for a fault 18 at a distance 0km from supply-side substation 40-1, very little current flows through non-supply side substation 40-2 at all, although most of that current flows through the relay supplying track 4. A small amount of current flows through the other relays, in the opposite direction. As the distance from supply-side substation 40-1 increases, the amount of current flowing through the non-supply side substation 40-2 increases. At all positions, most of that current flows through the relay supplying track 4. A small amount of current flows through the other relays, in the opposite direction.

In the event of a real-world ground short circuit fault being detected on track 4, stored measured voltage data from the relays associated with non-supply side substation 40-2 may be used, as described with reference to Fig. 5, to synchronise corresponding stored measured current data through the relays, and the relative magnitudes of those currents may be compared to the look-up table represented by Fig. 7. A certain location along the track is found at which the relative magnitudes of the currents measured through the relays of non-supply side substation 40-2 most resemble the relative magnitudes of the currents of the simulated data stored in the look up table. That certain location is the estimated location of the ground short circuit fault.

While each of the look up tables, represented in Fig. 6 and Fig. 7, may provide an estimate of the location of the ground short circuit fault 18, an improved estimate may be derived by combining the two estimates representing substations 40 at respective ends of the affected conductor 14. For example, an average location may be identified, mid-way between the two estimated locations, or a loading may be applied, such that the estimate provided by the substation 40 nearest the estimated location is given greater weight.

Although the present invention has been described with reference to a limited number of example supply arrangements, the principles of the invention explained herein may be expanded to apply the present invention to any arrangement of electrical supply to railway lines.

## Claims

1. A computer-implemented method for calculation of an estimated location of a ground fault short circuit (18) in a railway network power supply arrangement, wherein an electricity substation (40) supplies a number of respective conductors (14) with voltage and current by respective feeders (24) through respective relays (10, 12, 20, 22) which are arranged to measure the corresponding voltage and current,
the method comprising:

- performing computer-implemented simulations of ground fault short circuit events on respective conductors at selected locations on a railway network;
- storing, in a look-up table, data representing the selected locations and current and voltage changes during the simulated events as would be measured by the relays during the simulated ground fault short circuit events;
- measuring data representing current and voltage changes in respective feeders (24);
- detecting a ground fault short circuit (18) from a conductor (14) supplied by the substation (40);
- disconnecting power from an affected conductor (14) to eliminate current flow to the detected ground fault short circuit (18);
- storing the measured voltage and current data for associated track feeders at each substation directly feeding the fault (24a-24d) ;
- synchronisation of all measurement recordings by identifying the instants of maximum value of current and the instants of rapid change in voltage within the recorded data for each respective track feeder;
- comparing of ratios of stored instantaneous values of current and voltage in respective track feeders (24) due to the detected ground fault short circuit (18) with ratios of instantaneous values of current and voltage in respective track feeder (24) calculated during the simulations and stored in the look-up table;
- identifying a stored set of simulation data in the look-up table which most resembles the ratios of instantaneous values of current and voltage in respective track feeders (24) due to the detected ground fault short circuit (18); and
- identifying a location of a ground fault short circuit in the identified simulation as an estimated location of the detected ground fault short circuit.

2. A method according to claim 1, wherein the step of measuring and storing data representing current and voltage changes in respective feeders (24) due to the detected ground fault short circuit, following detection of the ground fault short circuit comprises the automated collection and synchronisation of data representing current and voltage changes in respective feeders (24), and identification of any track feeders (24) not in service during the detected ground fault short circuit.

3. A method according to claim 1 or claim 2, further comprising a post-processing step performed on the stored data representing voltages and current for each track feeder (24) and each conductor (14) to calculate a location estimate for the short circuit fault.

4. A method according to claim 3, wherein the post-processing step comprises:

- synchronising time signals of the measurements of the various track feeders (24);
- identifying an instant of peak instantaneous current; and
- comparing magnitudes of currents in the track feeders at the identified instant,

whereby an indication of the distance of the detected ground fault short circuit along the associated conductor, for each track feeder, is provided by relative proportions of currents in respective track feeders (24).

**Patentansprüche**

1. Computerimplementiertes Verfahren zur Berechnung eines geschätzten Standorts eines Erdschlusskurzschlusses (18) in einer Eisenbahnnetz-Stromversorgungsanordnung, wobei ein Elektrizitätsumspannwerk (40) eine Anzahl von jeweiligen Leitern (14) mit Spannung und Strom durch jeweilige Speisekabel (24) über jeweilige Relais (10, 12, 20, 22) versorgt, die angeordnet sind, um die entsprechende Spannung und den entsprechenden Strom zu messen, wobei das Verfahren Folgendes umfasst:

- Durchführen von computerimplementierten Simulationen von Erdschlusskurzschlussereignissen an jeweiligen Leitern an ausgewählten Standorten eines Eisenbahnnetzes;
- Speichern von Daten, welche die ausgewählten Standorte und Strom- und Spannungsänderungen während der simulierten Ereignisse darstellen, wie sie durch die Relais während der simulierten Erdschlusskurzschlussereignisse gemessen würden, in einer Nachschlagetabelle;
- Messen von Daten, die Strom- und Spannungsänderungen in jeweiligen Speisekabeln (24) darstellen;
- Erkennen eines Erdschlusskurzschlusses (18) von einem von durch das Umspannwerk (40) versorgten Leiter (14);
- Unterbrechen des Stroms zu einem betroffenen Leiter (14), um den Stromfluss zu dem erkannten Erdschlusskurzschluss (18) zu unterbinden;
- Speichern der gemessenen Spannungs- und Stromdaten für zugeordnete Gleisspeisekabel an jedem Umspannwerk, die den Fehler (24a-24d) direkt speisen;
- Synchronisieren aller Messaufzeichnungen durch Identifizieren der Zeitpunkte des maximalen Stromwerts und der Zeitpunkte schneller Spannungsänderungen innerhalb der aufgezeichneten Daten für jedes einzelne Gleisspeisekabel;
- Vergleichen von Verhältnissen von gespeicherten momentanen Werten von Strom und Spannung in den jeweiligen Gleisspeisekabeln (24) aufgrund des erkannten Erdschlusskurzschlusses (18) mit Verhältnissen von momentanen Werten von Strom und Spannung in jeweiligen Gleisspeisekabeln (24), die während der Simulationen berechnet und in der Nachschlagetabelle gespeichert wurden;
- Identifizieren eines gespeicherten Satzes von Simulationsdaten in der Nachschlagetabelle, der den Verhältnissen von momentanen Werten von Strom und Spannung in den jeweiligen Gleisspeisekabeln (24) aufgrund des erkannten Erdschlusskurzschlusses (18) am ähnlichsten ist; und
- Identifizieren eines Standorts eines Erdschlusskurzschlusses in der identifizierten Simulation als geschätzter Standort des erkannten Erdschlusskurzschlusses.

2. Verfahren nach Anspruch 1, wobei der Schritt des Messens und Speicherns von Daten, die Strom- und Spannungsänderungen in jeweiligen Speisekabeln (24) aufgrund des erkannten Erdschlusskurzschlusses darstellen, nach Erkennung des Erdschlusskurzschlusses die automatische Sammlung und Synchronisierung von Daten, die Strom- und Spannungsänderungen in jeweiligen Speisekabeln (24) darstellen, und die Identifizierung aller Gleisspeisekabel (24), die während des erkannten Erdschlusskurzschlusses nicht in Betrieb waren, umfasst.

3. Verfahren nach Anspruch 1 oder Anspruch 2, ferner umfassend einen Nachbearbeitungsschritt, der an den gespeicherten Daten durchgeführt wird, die Spannungen und Strom für jedes Speisekabel (24) und jeden Leiter (14) darstellen, um eine Standortschätzung für den Kurzschlussfehler zu berechnen.

4. Verfahren nach Anspruch 3, wobei der

Nachbearbeitungsschritt Folgendes umfasst:

- Synchronisieren von Zeitsignalen der Messungen der verschiedenen Gleisspeisekabel (24);
- Identifizieren eines Zeitpunkts eines momentanen Spitzenstroms; und
- Vergleichen von Stromstärken in den Gleisspeisekabeln zu dem identifizierten Zeitpunkt,

wodurch eine Angabe der Entfernung des erkannten Erdschlusskurzschlusses entlang des zugeordneten Leiters für jedes Gleisspeisekabel durch relative Anteile der Ströme in jeweiligen Gleisspeisekabeln (24) bereitgestellt wird.

**Revendications**

1. Procédé mis en œuvre par ordinateur pour le calcul d'un emplacement estimé d'un court-circuit de défaut de mise à la terre (18) dans un agencement d'alimentation électrique de réseau ferroviaire, dans lequel une sous-station électrique (40) alimente un certain nombre de conducteurs respectifs (14) en tension et en courant par des lignes d'alimentation respectives (24) par le biais de relais respectifs (10, 12, 20, 22) agencés pour mesurer la tension et le courant correspondants, le procédé comprenant :

   - la réalisation de simulations mises en œuvre par ordinateur d'événements de court-circuit de défaut de mise à la terre sur des conducteurs respectifs à des emplacements sélectionnés sur un réseau ferroviaire ;
   - le stockage, dans une table de consultation, de données représentant les emplacements sélectionnés et les variations de courant et de tension pendant les événements simulés tels qu'ils seraient mesurés par les relais pendant les événements de court-circuit de défaut de mise à la terre simulés ;
   - la mesure de données représentant des variations de courant et de tension dans des lignes d'alimentation respectives (24) ;
   - la détection d'un court-circuit de défaut de mise à la terre (18) à partir d'un conducteur (14) alimenté par la sous-station (40) ;
   - la déconnexion de l'alimentation à partir d'un conducteur affecté (14) pour éliminer le flux de courant vers le court-circuit de défaut de mise à la terre détecté (18) ;
   - le stockage des données de tension et de courant mesurées pour des lignes d'alimentation associées à chaque sous-station alimentant directement le défaut (24a-24d) ;
   - la synchronisation de tous les enregistrements de mesure en identifiant les instants de valeur maximale de courant et les instants de changement rapide de tension dans les données enregistrées pour chaque ligne d'alimentation respective ;
   - la comparaison de rapports de valeurs instantanées stockées de courant et de tension dans des lignes d'alimentation respectives (24) en raison du court-circuit de défaut de mise à la terre détecté (18) avec des rapports de valeurs instantanées de courant et de tension dans la ligne d'alimentation respective (24) calculés pendant les simulations et stockés dans la table de consultation ;
   - l'identification d'un ensemble stocké de données de simulation dans la table de consultation qui ressemble le plus aux rapports de valeurs instantanées de courant et de tension dans des lignes d'alimentation respectives (24) en raison du court-circuit de défaut de mise à la terre détecté (18) ; et
   - l'identification d'un emplacement d'un court-circuit de défaut de mise à la terre dans la simulation identifiée comme un emplacement estimé de court-circuit de défaut de mise à la terre détecté.

2. Procédé selon la revendication 1, dans lequel l'étape de mesure et de stockage de données représentant des variations de courant et de tension dans des lignes d'alimentation respectives (24) en raison du court-circuit de défaut de mise à la terre détecté, suite à la détection du court-circuit de défaut de mise à la terre, comprend la collecte et la synchronisation automatisées de données représentant des variations de courant et de tension dans des lignes d'alimentation respectives (24), et l'identification de toute ligne d'alimentation (24) non en service pendant le court-circuit de défaut de mise à la terre détecté.

3. Procédé selon la revendication 1 ou la revendication 2, comprenant également une étape de post-traitement réalisée sur les données stockées représentant des tensions et un courant pour chaque ligne d'alimentation (24) et chaque conducteur (14) pour calculer une estimation d'emplacement pour le défaut de court-circuit.

4. Procédé selon la revendication 3, dans lequel l'étape de post-traitement comprend :

   - la synchronisation de signaux temporels des mesures des différentes lignes d'alimentation (24) ;
   - l'identification d'un instant de courant instantané de pointe ; et

- la comparaison d'amplitudes de courants dans les lignes d'alimentation à l'instant identifié,

moyennant quoi une indication de la distance du court-circuit de défaut de mise à la terre détecté le long du conducteur associé, pour chaque ligne d'alimentation, est fournie par des proportions relatives de courants dans des lignes d'alimentation respectives (24).

FIG 1

EP 4 409 708 B1

FIG 2A

40 - 1

10 10 10 10

40 - 2

12 12 17 12 12

24b 24a 24a 24b

15 14 18 15

FIG 2B

## FIG 3A

## FIG 3B

FIG 4

FIG 5

EP 4 409 708 B1

## FIG 6

track 4

track 1    track 2, 3

distance along track [km]

## FIG 7

track 4

1.00  2.00  3.00  4.00  5.00  6.00  7.00  8.00  9.00  10.00

track 2, 3

track 1

distance along track [km]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 112180217 A

- CN 106443354 A